# EUROPÄISCHE PATENTSCHRIFT

(11) **EP 3 537 011 B1**
(45) Veröffentlichungstag und Bekanntmachung des Hinweises auf die Patenterteilung: **29.04.2020**
(21) Anmeldenummer: 19159888.7
(22) Anmeldetag: 28.02.2019
(51) Int. Cl.: F16J 15/06

(54) **VORSCHALTDICHTUNG**
BUFFER SEAL
JOINT TAMPON

(30) Priorität: 08.03.2018 DE 102018105376
(43) Veröffentlichungstag der Anmeldung: 11.09.2019
(73) Patentinhaber: Carl Freudenberg KG, 69469 Weinheim (DE)
(72) Erfinder: Colineau, Francois, 69469 Weinheim (DE); Hofmann, Jens, 68305 Mannheim (DE); Klenk, Thomas, Dr., 69221 Dossenheim (DE)

(56) Entgegenhaltungen:
- DE-A1- 2 621 352
- DE-A1-102012 017 805
- DE-A1-102013 000 982

## Beschreibung

### Technisches Gebiet

Die Erfindung betrifft eine Vorschaltdichtung für einen Dichtring, umfassend einen im Wesentlichen kreisringförmig ausgebildeten Potentialausgleichsring aus einem elektrisch leitfähigen Werkstoff, der dichtend mit einer abzudichtenden Oberfläche eines abzudichtenden Maschinenelements in Berührung bringbar ist.

### Stand der Technik

Aus der DE 10 2013 000 982 A1 ist eine Dichtung bekannt, die einen Dichtring mit zumindest einer dynamisch beanspruchten Dichtlippe und eine solche Vorschaltdichtung umfasst. Die Vorschaltdichtung ist mit axialem Abstand benachbart zur Dichtlippe angeordnet und besteht aus einem elektrisch leitfähigen Werkstoff. Die Dichtlippe und die Vorschaltdichtung umschließen eine abzudichtende Oberfläche eines abzudichtenden ersten Maschinenelements dichtend, wobei das erste Maschinenelement mit radialem Abstand benachbart zu einem zweiten Maschinenelement angeordnet ist. In dem durch den radialen Abstand gebildeten Spalt sind der Dichtring und die Vorschaltdichtung angeordnet. Das zweite Maschinenelement ist auf ein definiertes Massepotential geerdet, wobei das erste und das zweite Maschinenelement von der Vorschaltdichtung jeweils anliegend berührt und dadurch elektrisch leitend miteinander verbunden sind.
Die Vorschaltdichtung ist als Potentialausgleichsring ausgebildet und besteht zum Beispiel aus einem elektrisch leitfähigen, mit PTFE imprägnierten Vliesstoff. Eine mechanische Beschädigung der Maschinenelemente durch einen elektrischen Spannungsdurchschlag ist folglich ausgeschlossen.
Ohne den elektrischen Potentialausgleich könnten mechanische Beschädigungen der gegeneinander abzudichtenden Maschinenelemente dadurch entstehen, dass unterschiedlich große elektrische Potentiale der Maschinenelemente durch einen elektrischen Spannungsdurchschlag ausgeglichen werden. Ein solcher Spannungsdurchschlag ist umso wahrscheinlicher, je enger die Maschinenelemente mit unterschiedlichen elektrischen Potentialen einander benachbart zugeordnet sind. Ein Spannungsdurchschlag kann einen Materialabtrag an dem Maschinenelement mit relativ geringerer Ladung bewirken und eine Veränderung des Materialgefüges in dem Bereich, in dem der Spannungsdurchschlag erfolgt. Eine wirksame Abschirmung elektromagnetischer Störwellen, insbesondere eine wirksame Abschirmung von elektromagnetischen Störwellen mit einer Frequenz ≥ 30 MHZ, ist durch das Potentialausgleichselement nicht möglich.

Aus der DE 10 2014 010 269 A1 ist eine weitere Vorschaltdichtung bekannt. Die Vorschaltdichtung umfasst eine im Wesentlichen kreisringförmig ausgebildete Scheibe aus einem elektrisch leitfähigen und luftdurchlässigen Werkstoff und einen Tragkörper, wobei die Scheibe - bezogen auf den Tragkörper - als separat erzeugtes Einzelteil ausgebildet und mit dem Tragkörper verbunden ist.
Der Tragkörper kann durch einen Dichtring gebildet sein.

Die Vorschaltdichtung hat nicht nur die Aufgabe eines Potentialausgleichs sondern auch die Aufgabe, Verunreinigungen aus der Umgebung an einem Vordringen zur Dichtlippe des Dichtrings zu verhindern.
Die Vorschaltdichtung ist eine entkoppelte elektrische Brücke. Unter "entkoppelt" wird in diesem Zusammenhang verstanden, dass die Dichtfunktion eines zum Beispiel mit der Vorschaltdichtung kombinierten Dichtrings von der Funktion der elektrischen Brücke, nämlich einen Spannungsdurchschlag zu vermeiden und einen elektrischen Potentialausgleich zwischen Maschinenelementen zu bewirken, entkoppelt ist.
Die Vorschaltdichtung steht nicht in direktem Kontakt mit dem abzudichtenden Medium. Dabei ist von Vorteil, dass der elektrische Widerstand der Vorschaltdichtung während der gesamten Gebrauchsdauer der Vorschaltdichtung im Wesentlichen konstant ist. Würde die Vorschaltdichtung mit dem abzudichtenden Medium in Kontakt gelangen, würde sich der Widerstand unkalkulierbar verändern.

Aus der DE 10 2010 018 270 A1 ist eine elektrisch leitfähige Dichtungsanordnung bekannt, die in Hybrid- und Elektrofahrzeugen zur Anwendung gelangt. Die elektrisch leitfähige Dichtungsanordnung soll verhindern, dass verteilte RF-Energie zu unerwünschten Störungen führt, zum Beispiel zu Störungen eines Radios in einem Kraftfahrzeug. Diese unerwünschten Störungen sollen dadurch verhindert werden, dass der Dichtring aus einem elektrisch leitfähigen Werkstoff besteht und elektrisch leitend zwischen einer abzudichtenden Welle und einem Gehäuse angeordnet ist.

Generell sind die zuvor genannten, elektrisch leitfähigen Werkstoffe für eine zufriedenstellende Abschirmung elektromagnetischer Störwellen nicht gut geeignet, insbesondere dann nicht, wenn die Vorschaltdichtung im Zusammenhang mit e-mobility zur Anwendung gelangt und die elektromagnetischen Störwellen deshalb eine Frequenz haben, die häufig ≥ 30 MHZ ist.

### Darstellung der Erfindung

Der Erfindung liegt die Aufgabe zugrunde, eine Vorschaltdichtung der eingangs genannten Art derart weiterzuentwickeln, dass diese zusätzlich zur Abdichtfunktion weitere Funktionen aufweist und dadurch besonders vorteilhaft auf dem technischen Gebiet der "e-mobility" eingesetzt werden kann. Insbesondere sollen durch die Vorschaltdichtung elektromagnetische Störwellen mit einer Frequenz ≥ 30 MHZ wirksam abgeschirmt werden können.

Diese Aufgabe wird erfindungsgemäß durch eine Vorschaltdichtung gemäß Anspruch 1 gelöst.
Auf vorteilhafte Ausgestaltungen nehmen die auf Anspruch 1 direkt oder indirekt rückbezogenen Ansprüche Bezug.

Gelöst wird die Aufgabe durch eine Vorschaltdichtung für einen Dichtring, umfassend einen im Wesentlichen kreisringförmig ausgebildeten Potentialausgleichsring aus einem elektrisch leitfähigen Werkstoff, der dichtend mit einer abzudichtenden Oberfläche eines abzudichtenden Maschinenelements in Berührung bringbar ist und zumindest einen Abschirmring aus einem weichmagnetischen Werkstoff zur Abschirmung elektromagnetischer Störwellen.
Weichmagnetische Werkstoffe bewirken im Vergleich zu elektrisch leitfähigen Vliesstoffen oder elektrisch leitfähigen Polymeren eine stärkere Abschirmung aufgrund höherer Volumenanteile abschirmrelevanter Materialkomponenten. Wie zuvor ausgeführt, hat sich gezeigt, dass Potentialausgleichsringe, die zwingend aus einem elektrisch leitfähigen Werkstoff bestehen müssen, um ihre Funktion zu erfüllen, nicht gut geeignet sind, elektromagnetische Störwellen wirkungsvoll abzuschirmen. Insbesondere dann, wenn die elektromagnetischen Störwellen eine Frequenz ≥ 30 MHZ haben, ist die Abschirmung nur unzureichend.
Ein Abschirmring aus einem weichmagnetischen Werkstoff ist demgegenüber sehr gut geeignet, elektromagnetische Störwellen abzuschirmen. Selbst elektromagnetische Störwellen, wie sie im Bereich der e-mobility vorkommen, nämlich elektromagnetische Störwellen mit einer Frequenz ≥ 30 MHZ, lassen sich durch solche Abschirmringe wirkungsvoll abschirmen.
Durch die zur Anwendung gelangenden weichmagnetischen Werkstoffe, bei denen es sich um ferromagnetische Materialien handelt, ist der Abschirmring, im Gegensatz zu den zuvor beschriebenen Potentialausgleichsringen, elektrisch nicht leitfähig. Dadurch ist ein solcher Abschirmring als Potentialausgleichsring ungeeignet; eine andere Aufgabe als die Abschirmung elektromagnetischer Störwellen hat der Abschirmring nicht.

Die Vorschaltdichtung bewirkt durch den Potentialausgleichsring einen kontrollierten elektrischen Potentialausgleich zwischen Maschinenelementen und gleichzeitig durch den Abschirmring die Abschirmung elektromagnetischer Störwellen, wie sie insbesondere im Bereich e-mobility auftreten.
Eine mechanische Beschädigung der gegeneinander abzudichtenden Maschinenelemente durch eine elektrostatische Aufladung eines der Maschinenelemente und ein anschließender Spannungsdurchschlag zum anderen Maschinenelement mit einem anderen elektrischen Potential sind durch den Potentialausgleichsring ausgeschlossen. Während der bestimmungsgemäßen Verwendung der Vorschaltdichtung ist eines der gegeneinander abzudichtenden Maschinenelemente auf ein definiertes Massepotential (beispielsweise Karosserie eines Kraftfahrzeugs als elektrisches Massepotential) geerdet, sodass durch die elektrisch leitfähige Vorschaltdichtung ein Potentialausgleich zum anderen Maschinenelement erreicht wird.

Die Vorschaltdichtung ist eine entkoppelte elektrische Brücke. Unter "entkoppelt" wird in diesem Zusammenhang verstanden, dass die Dichtfunktion eines zum Beispiel mit der Vorschaltdichtung kombinierten Dichtrings von der Funktion der elektrischen Brücke, nämlich einen Spannungsdurchschlag zu vermeiden und einen elektrischen Potentialausgleich zwischen Maschinenelementen zu bewirken, entkoppelt ist.
Die Vorschaltdichtung steht nicht in direktem Kontakt mit dem abzudichtenden Medium. Dabei ist von Vorteil, dass der elektrische Widerstand der Vorschaltdichtung während der gesamten Gebrauchsdauer der Vorschaltdichtung im Wesentlichen konstant ist. Würde die Vorschaltdichtung mit dem abzudichtenden Medium in Kontakt gelangen, würde sich der Widerstand unkalkulierbar verändern.

Eine gute Wirkungsweise von Abschirmring und Potentialausgleich lässt sich nur dann gewährleisten, wenn eine strikte funktionale Trennung vorgenommen wird. Dadurch, dass der Abschirmring nicht elektrisch leitfähig/isolierend ist, ist er für einen Potentialausgleich nicht geeignet.
Umgekehrt kann ein Dichtring aus einem elektrisch leitfähigen Dichtungswerkstoff nicht für eine wirksame Abschirmung elektromagnetischer Störwellen sorgen, insbesondere dann nicht, wenn die elektromagnetischen Störwellen hochfrequent sind, in einem Frequenzbereich ≥ 30 MHZ. Auch ein separat erzeugter Potentialausgleichsring, der aus einem elektrisch leitfähigen Werkstoff besteht, ist dazu nicht in der Lage.

Der Potentialausgleichsring und der Abschirmring sind miteinander verbunden und bilden bevorzugt eine vormontierbare erste Einheit. Hierbei ist von Vorteil, dass die gebrauchsfertige Vorschaltdichtung nur aus der vormontierbaren ersten Einheit besteht und als Ganzes in eine Dichtungsanordnung eingebaut werden kann. Die Montage ist dadurch besonders einfach, und die Gefahr von Montagefehler ist auf ein Minimum begrenzt.

Gemäß einer vorteilhaften Ausgestaltung kann es vorgesehen sein, dass der Abschirmring durch einen Ferritring gebildet ist. Ein solcher Ferritring ist praktisch elektrisch nicht leitend/elektrisch isolierend. Der Ferritring kann aus Sinterkeramik bestehen. Die Werkstoffe, aus denen weichmagnetische Ferritringe bestehen, sind allgemein bekannt und nicht Gegenstand der vorliegenden Erfindung.
Dadurch, dass weichmagnetische Ferrite, wie zuvor beschrieben, elektrisch nicht leitfähig/isolierend sind, treten keine Wirbelstromverluste auf und sie sind sogar zur Abschirmung von elektromagnetischen Störwellen mit hohen Frequenzen im Bereich von ≥ 30 MHZ gut geeignet.

In Abhängigkeit von den jeweiligen Gegebenheiten des Anwendungsfalles, insbesondere in Abhängigkeit von der Frequenz der abzuschirmenden, elektromagnetischen Störwellen, kann es vorgesehen sein, dass zumindest zwei Abschirmringe in einer funktionstechnischen Reihenschaltung angeordnet sind.
Eine solche funktionstechnische Reihenschaltung kann dadurch erreicht werden, dass die zumindest zwei Abschirmringe in axialer Richtung benachbart zueinander angeordnet sind und eine vormontierbare Einheit bilden. Je höher die Anzahl der zur Anwendung gelangenden Abschirmringe, desto besser werden auch hochfrequente, elektromagnetische Störwellen bedämpft.

Die zumindest zwei Abschirmringe können eine vormontierbare zweite Einheit bilden. Die Montage der Vorschaltdichtung ist dadurch besonders einfach. Durch den modularen Aufbau der Abschirmringe kann die Einheit gut an die jeweiligen Gegebenheiten des Anwendungsfalles, insbesondere an die Höhe der abzuschirmenden Frequenz der elektromagnetischen Störwellen, angepasst werden.

Der Potentialausgleichsring kann durch einen luftdurchlässigen und elektrisch leitfähigen Vliesstoffring gebildet sein. Ein solcher Vliesstoffring ist, wie eingangs ausgeführt, zum Beispiel aus der DE 10 2013 000 982 A1 bekannt. Alternativ kann der Potentialausgleichsring aus einem elektrisch leitfähigen polymeren Werkstoff bestehen.
Abhängig vom Anwendungsfall können zum Beispiel zumindest zwei Potentialausgleichsringe vorgesehen sein.

Außerdem betrifft die Erfindung eine Dichtungsanordnung, umfassend eine Vorschaltdichtung, wie zuvor beschrieben, und einen Dichtring, wobei die Vorschaltdichtung auf der einem abzudichtenden Raum axial abgewandten Seite, also auf der der Umgebung zugewandten Seite des Dichtrings, angeordnet ist. Die Vorschaltdichtung kann zusammen mit den unterschiedlichsten Dichtringen zur Anwendung gelangen, wobei die Dichtringe durch Kombination mit der Vorschaltdichtung sehr gut geeignet sind, im Bereich e-mobility verwendet zu werden. Durch Kombination des Dichtrings mit der Vorschaltdichtung ist die gesamte Dichtungsanordnung gleichzeitig zur Abdichtung abzudichtender Medien geeignet, für einen guten Potentialausgleich und außerdem für eine wirksame Abschirmung elektromagnetischer Störwellen.
Sowohl die Vorschaltdichtung selbst als auch die Dichtungsanordnung sind jeweils multifunktional.

Die gegeneinander abzudichtenden Maschinenelemente können durch eine Antriebswelle eines Elektromotors gebildet sein und durch ein Gehäuse eines mit dem Elektromotor verbundenen und die Antriebswelle umschließenden Getriebes. Während der bestimmungsgemäßen Verwendung eines Elektromotors kann dessen Antriebswelle elektrostatisch aufgeladen werden, und elektromagnetische Störwellen entstehen. Diese spezielle Verwendung der Vorschaltdichtungsanordnung ist besonders vorteilhaft. Bilden der Elektromotor und das Getriebe gemeinsam die Antriebseinheit, kommt es durch den Betrieb des Elektromotors üblicherweise zu einer statischen Aufladung einzelner Bauteile der Antriebseinheit und damit zu Potentialdifferenzen zwischen den gegeneinander abzudichtenden Bauteilen. Diese Potentialdifferenzen müssen ausgeglichen werden, um unerwünschte Spannungsdurchschläge zu vermeiden. Außerdem entstehen während der bestimmungsgemäßen Verwendung elektromagnetische Störwellen im Bereich ≥ 30 MHZ, die durch den Abschirmring wirksam abgeschirmt werden, um Störungen im Umfeld der Vorschaltdichtung zu vermeiden.

Die Vorschaltdichtung und der Dichtring können eine vormontierbare dritte Einheit bilden. Diese dritte Einheit, umfassend die Vorschaltdichtung mit dem Potentialausgleichsring und den Abschirmring sowie den Dichtring, kann dann als Ganzes verbaut werden. Die Gefahr von Montagefehlern ist dadurch auf ein Minimum reduziert.

### Kurzbeschreibung der Zeichnung

Drei Ausführungsbeispiele der erfindungsgemäßen Vorschaltdichtung werden nachfolgend anhand der schematisch dargestellten Figuren 1 bis 3 näher erläutert.

Diese zeigen:
Figur 1 ein erstes Ausführungsbeispiel einer Vorschaltdichtung, die den Potentialausgleichsring und den Abschirmring umfasst,
Figur 2 ein zweites Ausführungsbeispiel, ähnlich dem Ausführungsbeispiel aus Figur 1, wobei zusätzlich ein weiterer Abschirmring zur Anwendung gelangt,
Figur 3 ein Ausführungsbeispiel einer Dichtungsanordnung, in der die Vorschaltdichtung gemäß Figur 1 zur Anwendung gelangt und zusätzlich ein Dichtring.

### Ausführung der Erfindung

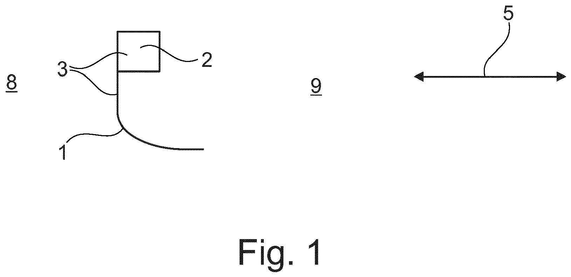

In den Figuren 1 bis 3 ist jeweils eine Vorschaltdichtung gezeigt, die den im Wesentlichen kreisringförmig ausgebildeten Potentialausgleichsring 1 und den Abschirmring 2 umfasst.
Der Potentialausgleichsring 1 besteht aus einem elektrisch leitfähigen Werkstoff, im gezeigten Ausführungsbeispiel aus einem luftdurchlässigen und elektrisch leitfähigen Vliesstoffring.
Der Abschirmring 2 besteht demgegenüber aus einem weichmagnetischen Werkstoff, der nicht elektrisch leitfähig/elektrisch isolierend ist.

Der Potentialausgleichsring 1 und der Abschirmring 2 bilden gemeinsam die vormontierbare erste Einheit 3.

In Figur 1 ist ein Ausführungsbeispiel einer Vorschaltdichtung in ihrer einfachsten Form gezeigt.

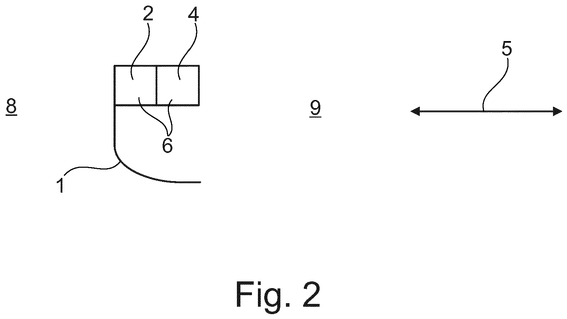

In Figur 2 ist ein zweites Ausführungsbeispiel gezeigt, das sich vom Ausführungsbeispiel aus Figur 1 dadurch unterscheidet, dass insgesamt zwei Abschirmringe 2, 4 zur Anwendung gelangen, die gemeinsam die vormontierbare zweite Einheit 6 bilden. Die beiden Abschirmringe 2, 4 sind in einer funktionstechnischen Reihenschaltung angeordnet, um die Wirkung der Abschirmung elektromagnetischer Störwellen zu verbessern.

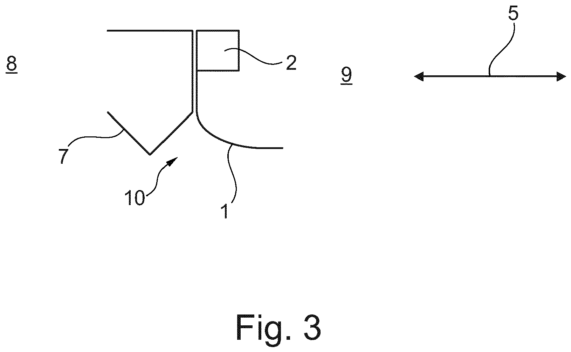

In Figur 3 ist eine Dichtungsanordnung gezeigt, die die Vorschaltdichtung gemäß Figur 1 umfasst. Die Vorschaltdichtung aus Figur 1 ist mit dem Dichtring 7 kombiniert, wobei die Vorschaltdichtung auf der einem abzudichtenden Raum 8 axial abgewandten Seite, nämlich auf der der Umgebung 9 zugewandten Seite des Dichtrings 7, angeordnet ist. Die Vorschaltdichtung, wie sie in Figur 1 dargestellt ist, also die erste Einheit 3, bildet zusammen mit dem Dichtring 7 die vormontierbare dritte Einheit 10.

## Patentansprüche

1. Vorschaltdichtung für einen Dichtring, umfassend einen im Wesentlichen kreisringförmig ausgebildeten Potentialausgleichsring (1) aus einem elektrisch leitfähigen Werkstoff, der dichtend mit einer abzudichtenden Oberfläche eines abzudichtenden Maschinenelements in Berührung bringbar ist , **dadurch gekennzeichnet dass** die Vorschaltdichtung zumindest einen Abschirmring (2, 4) aus einem weichmagnetischen Werkstoff zur Abschirmung elektromagnetischer Störwellen aufweist.

2. Vorschaltdichtung nach Anspruch 1, **dadurch gekennzeichnet, dass** der Potentialausgleichsring (1) und der Abschirmring (2, 4) miteinander verbunden sind und eine vormontierbare erste Einheit (3) bilden.

3. Vorschaltdichtung nach einem der Ansprüche 1 oder 2, **dadurch gekennzeichnet, dass** der Abschirmring (2, 4) als Ferritring ausgebildet ist.

4. Vorschaltdichtung nach einem der Ansprüche 1 bis 3, **dadurch gekennzeichnet, dass** zumindest zwei Abschirmringe (2, 4) in einer funktionstechnischen Reihenschaltung angeordnet sind.

5. Vorschaltdichtung nach Anspruch 4, **dadurch gekennzeichnet, dass** die zumindest zwei Abschirmringe (2, 4) in axialer Richtung (5) benachbart zueinander angeordnet sind.

6. Vorschaltdichtung nach einem der Ansprüche 4 oder 5, **dadurch gekennzeichnet, dass** die zumindest zwei Abschirmringe (2, 4) eine vormontierbare zweite Einheit (6) bilden.

7. Vorschaltdichtung nach einem der Ansprüche 1 oder 2, **dadurch gekennzeichnet, dass** der Potentialausgleichsring (1) durch einen luftdurchlässigen und elektrisch leitfähigen Vliesstoffring gebildet ist.

8. Dichtungsanordnung, umfassend eine Vorschaltdichtung nach einem der vorangegangenen Ansprüche und einen Dichtring (7), wobei die Vorschaltdichtung auf der einem abzudichtenden Raum (8) axial abgewandten Seite, auf der der Umgebung (9) zugewandten Seite des Dichtrings (7) angeordnet ist.

9. Dichtungsanordnung nach Anspruch 8, **dadurch gekennzeichnet, dass** die Vorschaltdichtung und der Dichtring (7) eine vormontierbare dritte Einheit (10) bilden.

## Claims

1. Buffer seal for a sealing ring, comprising an essentially circular potential equalizing ring (1) made of an electrically conductive material which can be brought into sealing contact with a surface to be sealed of a machine element to be sealed, **characterized in that** the buffer seal has at least one shielding ring (2, 4) made of a soft-magnetic material for shielding against electromagnetic interference waves.

2. Buffer seal according to Claim 1, **characterized in that** the potential equalizing ring (1) and the shielding ring (2, 4) are connected to one another and form a first unit (3) that can be preassembled.

3. Buffer seal according to either of Claims 1 and 2, **characterized in that** the shielding ring (2, 4) is designed as a ferrite ring.

4. Buffer seal according to one of Claims 1 to 3, **characterized in that** at least two shielding rings (2, 4) are arranged in a functional series configuration.

5. Buffer seal according to Claim 4, **characterized in that** the at least two shielding rings (2, 4) are arranged adjacent to one another in the axial direction (5).

6. Buffer seal according to either of Claims 4 and 5, **characterized in that** the at least two shielding rings (2, 4) form a second unit (6) that can be preassembled.

7. Buffer seal according to either of Claims 1 and 2, **characterized in that** the potential equalizing ring (1) consists of an air-permeable and electrically conductive fleece material ring.

8. Seal arrangement, comprising a buffer seal according to one of the preceding claims and a sealing ring (7), wherein the buffer seal is arranged on that side of the sealing ring (7) facing the surroundings (9), on the side facing axially away from a space (8) that is to be sealed.

9. Seal arrangement according to Claim 8, **characterized in that** the buffer seal and the sealing ring (7) form a third unit (10) that can be preassembled.

## Revendications

1. Joint d'étanchéité tampon pour une bague d'étanchéité, comprenant une bague d'équilibrage de potentiel (1) réalisée essentiellement sous forme annulaire circulaire, constituée d'un matériau électriquement conducteur, qui peut être amenée en contact hermétique avec une surface à étanchéifier d'un élément de machine à étanchéifier, **caractérisé en ce que** le joint d'étanchéité tampon présente au moins un anneau de blindage (2, 4) en matériau magnétique doux pour le blindage contre les ondes électromagnétiques parasites.

2. Joint d'étanchéité tampon selon la revendication 1, **caractérisé en ce que** la bague d'équilibrage de potentiel (1) et l'anneau de blindage (2, 4) sont connectés l'un à l'autre et forment une première unité prémontable (3).

3. Joint d'étanchéité tampon l'une quelconque des revendications 1 et 2, **caractérisé en ce que** l'anneau de blindage (2, 4) est réalisé sous forme d'anneau en ferrite.

4. Joint d'étanchéité tampon selon l'une quelconque des revendications 1 à 3, **caractérisé en ce qu'**au moins deux anneaux de blindage (2, 4) sont disposés suivant un montage technique fonctionnel en série.

5. Joint d'étanchéité tampon selon la revendication 4, **caractérisé en ce que** les au moins deux anneaux de blindage (2, 4) sont disposés de manière adjacente l'un à l'autre dans la direction axiale (5) .

6. Joint d'étanchéité tampon selon l'une quelconque des revendications 4 et 5, **caractérisé en ce que** les au moins deux anneaux de blindage (2, 4) forment une deuxième unité prémontable (6).

7. Joint d'étanchéité tampon selon l'une quelconque des revendications 1 et 2, **caractérisé en ce que** la bague d'équilibrage de potentiel (1) est formée par une bague en matériau non tissé perméable à l'air et électriquement conductrice.

8. Agencement d'étanchéité comprenant un joint d'étanchéité tampon selon l'une quelconque des revendications précédentes et une bague d'étanchéité (7), le joint d'étanchéité tampon étant disposé sur le côté axialement opposé à un espace (8) à étanchéifier, du côté de la bague d'étanchéité (7) tourné vers l'environnement (9).

9. Agencement d'étanchéité selon la revendication 8, **caractérisé en ce que** le joint d'étanchéité tampon et la bague d'étanchéité (7) forment une troisième unité prémontable (10).
